# EUROPEAN PATENT APPLICATION

(11) **EP 2 511 696 A1**
(43) Date of publication of application: **17.10.2012**
(21) Application number: 11161862.5
(22) Date of filing: 11.04.2011
(51) Int. Cl.: G01N 24/08, G01R 33/36, G01R 33/48, G01R 33/483, G01R 33/54, G01R 33/561, G01R 33/56

(54) **MRI of chemical species having different resonance frequencies using an ultra-short echo time sequence**

(71) Applicant: Koninklijke Philips Electronics N.V., 5621 BA Eindhoven (NL); Philips Intellectual Property & Standards GmbH, 20099 Hamburg (DE)
(72) Inventor: Keupp, Jochen, 5600 AE Eindhoven (NL); Caruthers, Shelton, D., 5600 AE Eindhoven (NL)
(74) Representative: Damen, Daniel Martijn

(57) **Abstract**

The invention relates to a method of MR imaging of chemical species having at least two different MR resonance frequencies, the method comprising the steps of:
- generating MR signals at that at least two different resonance frequencies of the chemical species by subjecting a portion of a body (10) to an imaging sequence of RF pulses and switched magnetic field gradients, which imaging sequence is an ultra-short echo time sequence;
- acquiring the MR signals;
- reconstructing a MR image from the acquired MR signals. Moreover, the invention relates to a MR device and to a computer program to be run on a MR device.

## Description

### TECHNICAL FIELD

The invention relates to the field of magnetic resonance (MR) imaging. It concerns a method of MR imaging of chemical species having at least two different resonance frequencies. The invention also relates to a MR device and to a computer program to be run on a MR device.

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

### BACKGROUND OF THE INVENTION

According to the MR method in general, the body of the patient to be examined is arranged in a strong, uniform magnetic field (B₀ field) whose direction at the same time defines an axis (normally the z-axis) of the co-ordinate system on which the measurement is based. The magnetic field produces different energy levels for the individual nuclear spins in dependence on the magnetic field strength which can be excited (spin resonance) by application of an electromagnetic alternating field (RF field, also referred to as B₁ field) of defined frequency (so-called Larmor frequency, or MR frequency). From a macroscopic point of view the distribution of the individual nuclear spins produces an overall magnetization which can be deflected out of the state of equilibrium by application of an electromagnetic pulse of appropriate frequency (RF pulse) while the magnetic field extends perpendicular to the z-axis, so that the magnetization performs a precessional motion about the z-axis. The precessional motion describes a surface of a cone whose angle of aperture is referred to as flip angle. The magnitude of the flip angle is dependent on the strength and the duration of the applied electromagnetic pulse. In the case of a so-called 90° pulse, the spins are deflected from the z axis to the transverse plane (flip angle 90°).

After termination of the RF pulse, the magnetization relaxes back to the original state of equilibrium, in which the magnetization in the z direction is built up again with a first time constant T₁ (spin lattice or longitudinal relaxation time), and the magnetization in the direction perpendicular to the z direction relaxes with a second time constant T₂ (spin-spin or transverse relaxation time). The variation of the magnetization can be detected by means of one or more receiving RF coils which are arranged and oriented within an examination volume of the MR device in such a manner that the variation of the magnetization is measured in the direction perpendicular to the z-axis. The decay of the transverse magnetization is accompanied, after application of, for example, a 90° pulse, by a transition of the nuclear spins (induced by local magnetic field inhomogeneity) from an ordered state with the same phase to a state in which all phase angles are uniformly distributed (dephasing). The dephasing can be compensated by means of a refocusing pulse (for example a 180° pulse). This produces an echo signal (spin echo) in the receiving coils.

In order to realize spatial resolution in the body, linear magnetic field gradients extending along the three main axes are superposed on the uniform magnetic field, leading to a linear spatial dependency of the spin resonance frequency. The signal picked up in the receiving coils then contains components of different frequencies which can be associated with different locations in the body. The MR signal data obtained via the RF coils corresponds to the spatial frequency domain and is called k-space data. The k-space data usually includes multiple lines acquired with different phase encoding. Each line is digitized by collecting a number of samples. A set of k-space data is converted to a MR image by means of Fourier transformation or other appropriate reconstruction algorithms.

In many clinically relevant MR imaging applications - based on magnetic resonance of protons or other nuclei (for example ¹⁹F) - MR signals from chemical species have to be detected and, as the case may be, quantified, wherein the nuclei of the chemical species resonate at several distinct frequency components due to different chemical shift of the respective nuclei. Such spectra of several resonance frequency components are typically found at small or large irregular frequency distances within a given bandwidth. The different components may exhibit different relaxation properties as well as variable hetero- or homonuclear coupling effects.

Important examples for such MR imaging techniques are diagnostics or treatment monitoring based on agents comprising chemical species having multiple resonance frequencies. Of particular interest are so-called targeted agents containing non-proton (for example ¹⁹F) MR imaging labels. Examples are perfluoro-octyl-bromide (PFOB) labeled, angiogenesis targeted nanoparticles. The ¹⁹F MR spectrum of the latter agent includes several distinct frequency components due to different chemical shift at different positions of the fluorine nuclei within the PFOB molecule.

MR imaging of multi-resonant MR imaging agents or labels comprising two or more different resonance frequencies has been addressed, for example, by MR spectroscopic imaging. A drawback of MR spectroscopic imaging is its low scan time efficiency, which is caused by the fact that all spatial dimensions have to be covered by step-wise phase-encoding procedures. In standard MR imaging (like, for example, gradient-echo imaging, turbo-spin-echo imaging, or steady-state free precession imaging), the frequency encoding of one spatial dimension leads to a high scan time efficiency but results in artifacts in case multiple chemical shift-related resonance frequency components are present. A large number of approaches to overcome these problems have been proposed and tested. However, in the known approaches either a significant amount of MR signal strength is sacrificed (see Gireaudeau et al., MRM 63: 1119-1124, 2010) or the separation of the different chemical shift resonance frequency components relies on computationally demanding and potentially unstable reconstruction techniques (see Posse et al., Radiology, 192: 733-738, 1994). In particular, known MR imaging techniques that are used for the separation of MR signals emanating from protons within lipid molecules (fat) and water protons (i.e. two chemical species), which can already be found in clinical practice, are less favorable, when more than two chemical shift resonance frequency components are present which exhibit variable relaxation properties.

Moreover, the application of targeted molecular MR imaging agents involves specific challenges since MR signals emanating from target bound agents have to be observed. The target binding modifies the MR relaxation properties of the MR imaging label. Typically, the tight target binding results in a significantly shortened T₂ relaxation time. This restricts the application of imaging sequences with multiple spin (or gradient) echoes. Very short echo times have to be used in order to obtain a sufficient signal-to-noise ratio in the reconstructed MR image. On the other hand, short echo times in the region of 1-2 ms are often sub-optimal, because those chemical shift resonance frequency components, which are closely spaced in the spectrum, may be in opposite phase at the respective echo time. This leads to signal cancellation and, finally, to a reduced signal-to-noise ratio.

From the foregoing it is readily appreciated that there is a need for an improved method of MR imaging of chemical species having two or more different resonance frequencies.

### SUMMARY OF THE INVENTION

In accordance with the invention, a method of MR imaging of chemical species having at least two different resonance frequencies is disclosed. The method of the invention comprises the steps of:
- generating MR signals of at the at least two different resonance frequencies by subjecting a portion of a body to an imaging sequence of RF pulses and switched magnetic field gradients, which imaging sequence is an ultra-short echo time sequence;
- acquiring the MR signals;
- reconstructing a MR image from the acquired MR signals.

The basic idea of the invention is to utilize an ultra-short echo time MR imaging technique with free-induction-decay (FID) acquisition. Ultra-short echo time imaging allows the acquisition of MR signal components with T₂ relaxation times on the order of only a few hundred microseconds as they occur in target bound MR imaging agents (see above).

According to the invention, the echo time of the ultra-short echo time sequence is preferably 0-200 µs. This means that the acquisition of the MR signals starts after 0-200 µs after an excitation RF pulse of the imaging sequence. The MR signals can then be acquired as FID signals during an acquisition interval ending before the phase difference of the MR signal components at the at least two resonance frequencies exceeds 90°. According to the invention, the MR signals of the nuclei having different resonance frequencies are jointly excited by the imaging sequence and contribute to the acquired MR signals, wherein the accumulated phase difference of the MR signals of the at least two spectral components during the acquisition interval is small. Thus, within the FID signal, the different spectral components add coherently in the acquired MR signals and ensure optimal signal strength. In this way, a high signal-to-noise ratio can be obtained and even signal quantification is enabled.

The useful acquisition interval after the excitation RF pulse for coherent FID acquisition of different resonance frequency components depends on the frequency spacing of the chemical shifts involved. For chemical shift resonance frequency components within a bandwidth of 1 kHz (like, for example, the frequency components of the CF₂ spectral line group in the MR spectrum of PFOB) the duration of the acquisition interval amounts to about 0.5 ms. The achievable spatial resolution of the approach of the invention depends on the time integral of the applied magnetic field gradient, i.e. the gradient performance of the used MR device. The available gradient performance of MR devices in clinical use at present is typically sufficient for detection of targeted MR imaging agents with a voxel size of about 1 mm³ according to the invention.

According to a preferred embodiment of the invention, the imaging sequence is applied according to a steady-state free precession technique. A steady-state free precession technique within the meaning of the invention is any technique, in which the imaging sequence is applied in such a manner that a non-zero steady-state of the transverse and longitudinal nuclear magnetization develops. A pre-requisite for the generation of such a steady-state is that the repetition time of the imaging sequence is shorter than the T₁ and T₂ relaxation times involved. This means that the excitation RF pulses that are successively applied are close enough together such that the generated MR signal will never decay completely. The flip angle of the excitation RF pulse in a steady state free precession sequence is typically between 45° and 60°. The application of the imaging sequence according to a steady-state free precession technique according to the invention further increases the signal-to-noise ratio because of the favorable T₁/T₂ contrast, in particular for MR imaging agents with long T₁ and short (apparent) T₂. A fast repetition time of, for example less than 5 ms or, preferably, less than 2 ms is possible for a steady state free precession technique in combination with ultra-short echo times and FID acquisition. The fast repetition time helps to acquire a large number of MR signals (FIDs) within a short overall measurement time, thereby providing a good time efficiency of the technique.

Most preferably, the imaging sequence of the invention is applied according to a balanced steady-state free precession technique. The balanced switched magnetic field gradients maintain the transverse and longitudinal nuclear magnetization. This results in a further optimized signal-to-noise ratio. The combination of an ultra-short echo time sequence with (balanced) steady-state free precession according to the invention is ideal to cope with the above described challenges, like very short (apparent) T₂ due to, for example, multi-nuclear coupling in target bound MR imaging agents and relaxation shortening effects.

According to another preferred embodiment of the invention, the MR signals are acquired according to a 2D or 3D radial k-space sampling scheme. The ultra-short echo time sequence of the invention can be implemented using so-called half-sinc RF excitation pulses and 2D radial k-space sampling of the FID. Slice selection may be achieved by adding the MR signals of two acquisition steps of the same FID excited with slice-selection magnetic field gradients of opposite sign (see Pauly et al., Proceedings of the 8th Annual Meeting of SMRM, 1998, p. 28). Alternatively, 3D radial k-space sampling may be used which employs a non-selective excitation RF pulse with 3D radial FID acquisition, yielding MR signal data with isotropic spatial resolution (see Wu et al., MRM 50: 59-68, 2003). Using this approach, the RF excitation is more robust and of shorter duration, thereby minimizing T₂ decay during excitation. With the radial k-space sampling scheme, an echo time in the order of 0-200 µs will ensure that the maximum MR signal strength at the top of the FID is used for MR signals from central k-space for optimal signal-to-noise ratio even in the case of a very short (apparent) T₂. Beyond 2D and 3D radial k-space sampling, any other sampling technique is applicable in accordance with the invention, which starts at the centre of k-space for the FID acquisition and successively samples the peripheral k-space regions, like for example in spiral k-space sampling.

According to yet another preferred embodiment of the invention, MR signals of two distinct nuclear species (for example ¹⁹F and ¹H) are excited by means of the imaging sequence, which comprises RF pulses generated at distinct resonance frequencies of the two nuclear species, and wherein the MR signals of the two nuclear species are acquired in parallel. This means that the approach of the invention is combined with a simultaneous dual-nuclei technique, which can be used advantageously for efficient anatomical localization. For at least one the nuclear species, the MR signals consist of different frequency components, which are advantageously acquired with improved signal-to-noise ratio according to the invention.

According to still a further preferred embodiment of the invention, the imaging sequence comprises a preparation RF pulse for lipid or blood-pool suppression. For example, a black blood technique may be combined with the approach of the invention to improve segmentation of body tissue from the blood pool. Black blood techniques decrease the MR signal contribution from blood. This is achieved by means of a preparation RF pulse which saturates the MR signal from blood. The technique makes use of the flow void effect as the pre-saturated blood passes through the imaged body portion. Lipid suppression can be achieved in a per se known manner by means of frequency-selective pre-saturation.

A preparation RF pulse may be introduced for any kind of selective excitation and/or suppression of MR signal contributions, for example in order to isolate MR signals from cerebrospinal fluid (CSF) or to distinguish between a 'free' fraction and a bound fraction of a targeted MR imaging agent.

The method of the invention described thus far can be carried out by means of a MR device including at least one main magnet coil for generating a uniform steady magnetic field within an examination volume, a number of gradient coils for generating switched magnetic field gradients in different spatial directions within the examination volume, at least one RF coil for generating RF pulses within the examination volume and/or for receiving MR signals from a body of a patient positioned in the examination volume, a control unit for controlling the temporal succession of RF pulses and switched magnetic field gradients, a reconstruction unit, and a visualization unit. The method of the invention is preferably implemented by a corresponding programming of the reconstruction unit, the visualization unit, and/or the control unit of the MR device.

The methods of the invention can be advantageously carried out in most MR devices in clinical use at present. To this end it is merely necessary to utilize a computer program by which the MR device is controlled such that it performs the above-explained method steps of the invention. The computer program may be present either on a data carrier or be present in a data network so as to be downloaded for installation in the control unit of the MR device.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 schematically shows a MR device for carrying out the methods of the invention;
Fig. 2 shows a diagram illustrating the acquisition of a FID signal of a PFOB agent according to method of the invention.

### DETAILED DESCRIPTION OF THE EMBODIMENTS

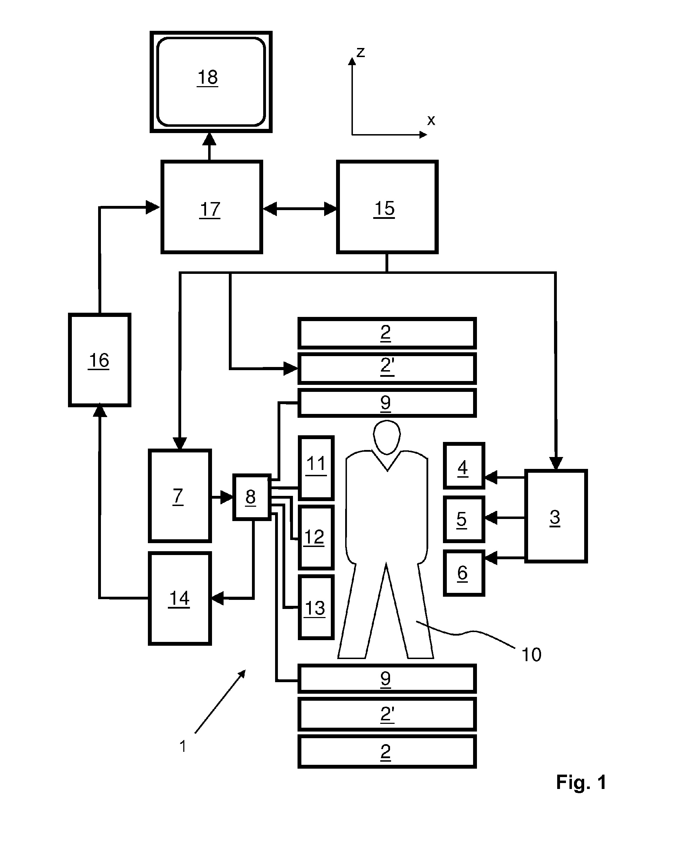

With reference to Figure 1, a MR device 1 is shown. The device comprises superconducting or resistive main magnet coils 2 such that a substantially uniform, temporally constant main magnetic field B₀ is created along a z-axis through an examination volume. The device further comprises a set of (1^{st}, 2^{nd}, and - where applicable - 3^{rd} order) shimming coils 2', wherein the current flow through the individual shimming coils of the set 2' is controllable for the purpose of minimizing B₀ deviations within the examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

Most specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send-/receive switch 8, to a -body RF coil 9 to transmit RF pulses into the examination volume. A typical MR imaging sequence is composed of a packet of RF pulse segments of short duration which taken together with each other and any applied magnetic field gradients achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals are also picked up by the body RF coil 9.

For generation of MR images of limited regions of the body 10 by means of parallel imaging, a set of local array RF coils 11, 12, 13 are placed contiguous to the region selected for imaging. The array coils 11, 12, 13 can be used to receive MR signals induced by body-coil RF transmissions.

The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via send-/receive switch 8.

A host computer 15 controls the current flow through the shimming coils 2' as well as the gradient pulse amplifier 3 and the transmitter 7 to generate any of a plurality of MR imaging sequences, such as echo planar imaging (EPI), echo volume imaging, gradient and spin echo imaging, fast spin echo imaging, and the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. In modem MR devices the data acquisition system 16 is a separate computer which is specialized in acquisition of raw image data.

Ultimately, the digital raw image data is reconstructed into an image representation by a reconstruction processor 17 which applies a Fourier transform or other appropriate reconstruction algorithms, such like SENSE or GRAPPA. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a human-readable display of the resultant MR image.

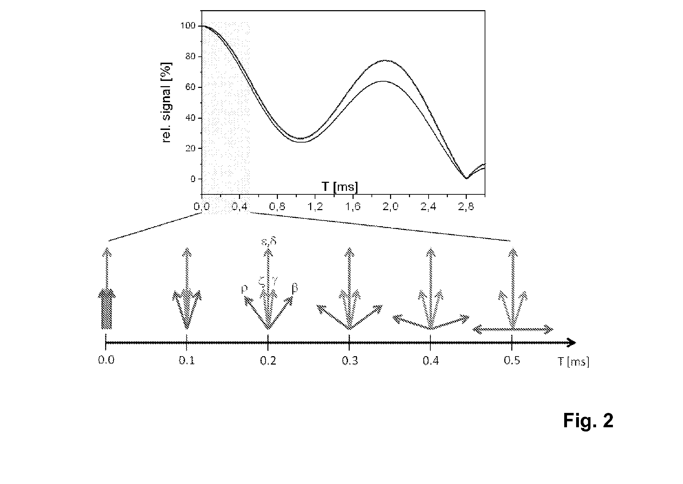

Figure 2 shows a diagram illustrating the acquisition of a FID signal of a perfluoro-octyl-bromide (PFOB) labeled MR imaging agent according to the method of the invention by means of a radial k-space sampling scheme. As explained above, the basic idea of the invention is to utilize an ultra-short echo time sequence in combination with a balanced stead-state free precession technique, wherein FID signals are acquired after excitation RF pulses of the used imaging sequence in rapid succession. The upper diagram in Figure 2 shows the FID signal acquired at the ¹⁹F MR resonance frequency on a 3T MR device as depicted in Figure 1. The upper curve in the diagram reflects the FID without T₂ relaxation, while the lower curve corresponds to the FID signal with T₂ relaxation. The lower diagram in Figure 2 illustrates the de-phasing of the different chemical shift resonance frequency components (designated by p, ζ, ε, δ, γ, β) of the PFOB CF₂ group of resonance frequency lines with increasing acquisition time T. At the beginning of the FID, all resonance frequency components are in phase and contribute coherently to the acquired MR signal. The maximum phase difference stays within a phase range of +- 90° for about 0.5 ms. With an ultra-short echo time (i.e. the time interval between the centre of the excitation RF pulse and the start of the FID acquisition) of 100 µs, the acquisition of the FID signal according to the invention lasts for about 0.6 ms. A spatial resolution of about 1 mm is achieved with a gradient performance of 200 mT/m/s.

The ultra-short echo time approach in combination with FID acquisition and a steady-state free precession technique according to the invention enables very robust and fast acquisition of MR signals from MR imaging agents having a plurality of chemical shift resonance frequency components. Because all frequency components of the different chemical species contribute coherently to the acquired MR signals, a signal-to-noise ratio is obtained which is significantly higher than in conventional approaches.

The technique of the invention can be used for acquisition of MR signals from a single non-proton nucleus (e.g. ¹⁹F), while anatomical background information is acquired by means of a separate (¹H) MR imaging session. Alternatively, the ultra-short echo time approach of the invention can be used in combination with dual-nuclei acquisition (e.g. ¹⁹F and ¹H), wherein the RF excitation is extended to two distinct resonance frequencies of the different nuclei via two separate transmission channels of the MR device. The FID signals are acquired on both resonance frequencies concurrently, for example via a dual-tuned RF coil and recorded via separate recievers. This approach enables the simultaneous acquisition of anatomical information on the ¹H channel in combination with the high signal-to-noise detection of MR signals from the MR imaging agent via the above described ultra-short echo time technique on the ¹⁹F channel. Motion information obtained via ¹H imaging, relating for example to breathing or swallowing motion of the examined patient, can be used to correct the non-proton MR image in order to eliminate motion artifacts. Signal blurring in the reconstructed MR image can be reduced in this way, thereby facilitating the quantification of the MR imaging agent.

Furthermore, within the quickly repeating ultra-short echo time sequence of the invention, preparation RF pulses for lipid or blood-pool suppression can be introduced. Black blood preparation RF pulses are particularly useful for detection of intra-vascular targeted MR imaging agents because a clear separation of the blood fraction and the endothelial-bound fraction of the MR imaging agent is achieved. A preferred application of the method of the invention is thus the detection and quantification of targeted nanoparticles for assessment of the angiogenic state in carotid arteries.

## Claims

1. Method of MR imaging of chemical species having at least two different resonance frequencies, the method comprising the steps of:
- generating MR signals at the at least two different resonance frequencies of the chemical species by subjecting a portion of a body (10) to an imaging sequence of RF pulses and switched magnetic field gradients, which imaging sequence is an ultra-short echo time sequence;
- acquiring the MR signals;
- reconstructing a MR image from the acquired MR signals.

2. Method of claim 1, wherein the echo time of the ultra-short echo time sequence is 0-200 µs.

3. Method of claim 2, wherein the MR signals are acquired as free-induction-decay signals during an acquisition interval ending before the phase difference of the MR signals at the at least two different resonance frequencies exceeds 90°.

4. Method of claim 3, wherein the duration of the acquisition interval is less than 2 ms, preferably less than 1 ms.

5. Method of any one of claims 1-4, wherein the imaging sequence is applied according to a steady state free precession technique.

6. Method of claim 5, wherein the repetition time of the imaging sequence is less than 5 ms, preferably less than 2 ms.

7. Method of any one of claims 1-6, wherein the MR signals are acquired according to a 2D or 3D radial k-space sampling scheme.

8. Method of any one of claims 1-7, wherein MR signals of two or more nuclear species are excited by means of the imaging sequence, which comprises RF pulses generated at distinct resonance frequencies of the two or more nuclear species, and wherein the MR signals of the two or more nuclear species are acquired in parallel.

9. Method of any one of claims 1-8, wherein the imaging sequence comprises a preparation RF pulse for lipid or blood-pool suppression.

10. MR device comprising at least one main magnet coil (2) for generating a uniform, steady magnetic field within an examination volume, a number of gradient coils (4, 5, 6) for generating switched magnetic field gradients in different spatial directions within the examination volume, at least one RF coil (9) for generating RF pulses within the examination volume and/or for receiving MR signals from a body (10) of a patient positioned in the examination volume, a control unit (15) for controlling the temporal succession of RF pulses and switched magnetic field gradients, a reconstruction unit (17), and a visualization unit (18), wherein the MR device (1) is arranged to perform the following steps:
- generating MR signals of chemical species having at least two different resonance frequencies by subjecting the portion of the body (10) to an imaging sequence of RF pulses and switched magnetic field gradients, which imaging sequence is an ultra-short echo time sequence;
- acquiring the MR signals;
- reconstructing a MR image from the acquired MR signals.

11. MR device of claim 10, wherein the at least one RF coil (9) is tuned to disctinct resonance frequencies of two or more nuclear species.

12. Computer program to be run on a MR device, which computer program comprises instructions for:
- generating an imaging sequence of RF pulses and switched magnetic field gradients, which imaging sequence is an ultra-short echo time sequence;
- acquiring the MR signals;
- reconstructing a MR image from the acquired MR signals with contributions from chemical species having at least two different resonance frequencies.
